(19) **Europäisches Patentamt**
**European Patent Office**
**Office européen des brevets**

(11) **EP 4 651 183 A1**

(12) **EUROPEAN PATENT APPLICATION**

(43) Date of publication:
**19.11.2025 Bulletin 2025/47**

(21) Application number: **24175943.0**

(22) Date of filing: **15.05.2024**

(51) International Patent Classification (IPC):
**H01L 21/329** (2006.01)   **H01L 29/866** (2006.01)
**H01L 29/06** (2006.01)

(52) Cooperative Patent Classification (CPC):
**H10D 8/25; H10D 8/022;** H10D 62/126

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **NXP B.V.**
**5656 AG Eindhoven (NL)**

(72) Inventors:
- **Mehrotra, Saumitra Raj**
  **5656 AG Eindhoven (NL)**
- **Cheng, Xu**
  **5656 AG Eindhoven (NL)**
- **Zhu, Ronghua**
  **5656 AG Eindhoven (NL)**

(74) Representative: **Schmütz, Christian Klaus
Johannes
NXP Semiconductors Germany GmbH
Intellectual Property Group
Beiersdorfstr. 12
22529 Hamburg (DE)**

(54) **A ZENER DIODE**

(57)     A Zener diode comprising: a PN junction formed in a semiconductor material; and one or more stress-inducing regions configured to impart a compressive stress in the PN junction along a current flow direction of the PN junction.

Figure 1A

# Description

## Field

The present disclosure relates to a Zener diode and methods of manufacturing Zener diodes.

## Backaround

Zener diodes are a type of diode that are designed to reliably allow current to flow "backwards" when a certain set reverse voltage, known as the Zener voltage, is reached.

Zener diodes are typically made from two differently doped layers of semiconductor material that form a PN junction. The P-type material has a surplus of positive charge carriers (holes) and the N-type, a surplus of electrons. Zener diodes can be made by heavily doping N-type and P-type semiconductors. The excessive doping reduces the depletion width resulting in a weaker barrier and a low breakdown voltage.

Zener diodes can be used to provide reference voltages for circuits. Additional applications include generating low-power stabilized supply rails from a higher voltage and protecting circuits from overvoltage, especially electrostatic discharge.

## Summary

According to a first aspect of the present disclosure there is provided a Zener diode comprising:

> a PN junction formed in a semiconductor material; and
> one or more stress-inducing regions configured to impart a compressive stress in the PN junction along a current flow direction of the PN junction.

In one or more embodiments the PN junction may comprise a N-type region in contact with a P-type region. The current flow direction may be perpendicular to an interface of the N-type region with the P-type region.

In one or more embodiments the PN junction may comprise a N-type region in contact with a P-type region. The one or more stress-inducing regions may comprise one or more of:

> a first stress-inducing region in contact with the P-type region; and
> a second stress-inducing region in contact with the N-type region.

In one or more embodiments, one or more dimensions of the one or more stress-inducing regions may be selected to control a value of the compressive stress in the PN junction along the current flow direction of the PN junction.

In one or more embodiments, the Zener diode may comprise a layered structure including:

> a first layer formed in the semiconductor material;
> a second layer formed in the semiconductor material between the first layer and a surface of the semiconductor material; and
> a stress-inducing layer positioned on the surface of the semiconductor material to form one of the one or more stress-inducing regions,
> wherein the first layer and the second layer each comprise a different one of a P-type region and a N-type region to form the PN junction.

In one or more embodiments, the first layer may comprise a P-type region and the second layer may comprise a N-type region. The first layer may comprise a N-type region and the second layer may comprise a P-type region. The current flow direction may be perpendicular to the interface of the first layer and the second layer.

In one or more embodiments, the stress-inducing layer may comprise a tensile stressed layer configured to impart a tensile stress to the second layer in one or more axes parallel to a plane of the second layer. The stress-inducing layer may comprise a tensile stressed layer configured to impart a tensile stress to the second layer in one or more axes parallel to a plane of the second layer such that a compressive stress is imparted along the current flow direction in an axis perpendicular to the plane of the second layer.

In one or more embodiments, the stress-inducing layer may comprise a biaxial tensile stressed layer.

In one or more embodiments, the stress-inducing layer may be indirectly positioned on the surface of the semiconductor material. An oxide layer may be positioned between the surface of the semiconductor material and the stress-inducing layer.

In one or more embodiments, the PN junction may be formed between a first stress-inducing region and a second stress-inducing region.

In one or more embodiments, the PN junction may comprise a N-type region positioned adjacent to a P-type region with an interface between the N-type region and the P-type region being perpendicular to a top surface of the semiconductor material. The one or more stress-inducing regions may comprise one or more of:

> a first stress-inducing region adjacent to the P-type region on an opposite side to the N-type region; and
> a second stress-inducing region adjacent to the N-type region on an opposite side to the P-type region.

In one or more embodiments, the one or more stress-inducing regions may each comprise a shallow trench isolation feature.

In one or more embodiments, the one or more stress-inducing regions may comprise:

a first stress-inducing region adjacent to the P-type region on an opposite side to the N-type region; and a second stress-inducing region adjacent to the N-type region on an opposite side to the P-type region, wherein a separation of the first stress-inducing region and the second stress-inducing region is selected to control a value of the compressive stress in the PN junction in the current flow direction.

In one or more embodiments, the Zener diode may comprise:

a first region formed in the semiconductor material; and
a second region formed in the semiconductor material and surrounding the first region to form a PN junction in a junction plane, wherein the first region and the second region each comprise a different one of a P-type region and a N-type region to form the PN junction,
wherein the one or more stress-inducing regions include a stress-inducing region surrounding the second region.

In one or more embodiments, the stress-inducing region may comprise a shallow trench isolation feature.

In one or more embodiments, the semiconductor material may comprise Silicon.

In one or more embodiments, a value of the compressive stress may be between 150 MPa and 200MPa.

According to a second aspect of the present disclosure there is provided an integrated circuit comprising any of the Zener diodes disclosed herein.

According to a third aspect of the present disclosure there is provided a voltage reference circuit comprising any Zener diode or integrated circuit disclosed herein.

According to a fourth aspect of the present disclosure, there is provided a method of manufacturing a Zener diode comprising the steps of:

providing a semiconductor material;
forming a PN junction in the semiconductor material; and
forming one or more stress-inducing regions in or on the semiconductor material, wherein the one or more stress-inducing regions are configured to impart a compressive stress in the PN junction along a current flow direction of the PN junction.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

## Brief Description of the Drawings

One or more embodiments will now be described by way of example only with reference to the accompanying drawings in which:

Figure 1A shows an example Zener diode according to an embodiment of the present disclosure;
Figure 1B shows a second example Zener diode according to an embodiment of the present disclosure;
Figure 1C shows a third example Zener diode according to an embodiment of the present disclosure;
Figures 2A to 2E illustrate a process for manufacturing the Zener diode of Figure 1A according to an embodiment of the present disclosure;
Figures 3A to 3D illustrate a process for manufacturing the Zener diode of Figure 1B according to an embodiment of the present disclosure;
Figure 4 illustrates a method of manufacturing a Zener diode according to an embodiment of the present disclosure;
Figure 5A illustrates a measured variation in breakdown voltage in response to the application of compressive stress along a current flow direction of a PN junction of a Zener diode;
Figure 5B illustrates a measured variation in breakdown voltage in response to the application of tensile stress along a current flow direction of a PN junction of a Zener diode; and
Figure 6 illustrates a simulation of the variation in Zener breakdown voltage in dependence of stress along the current flow direction.

## Detailed Description

Precision analog circuitry can require accurate voltage reference circuits. A Zener diode can be a critical component in circuit operation of Zener reference circuits. An integrated circuit (IC) chip may undergo multiple thermal cycles during qualification that change the package stress. The resulting stress buildup can impact a Zener breakdown voltage of the Zener diode and affect the accuracy of the analog circuitry. One such application of Zener reference circuits is a battery management system (BMS). A BMS can require a battery cell voltage measurement accuracy of +/- 1 mV over a 5 V cell (+/- 0.02%). However, drift in the Zener breakdown voltage due to packaging and aging can be on the order of 0.1%.

Hence there is a need for a stress immune Zener diode design.

The present disclosure provides a Zener diode incorporating built-in compressive stress along a current flow direction that provides for reduced sensitivity of the Zener breakdown voltage to package stress or external stress.

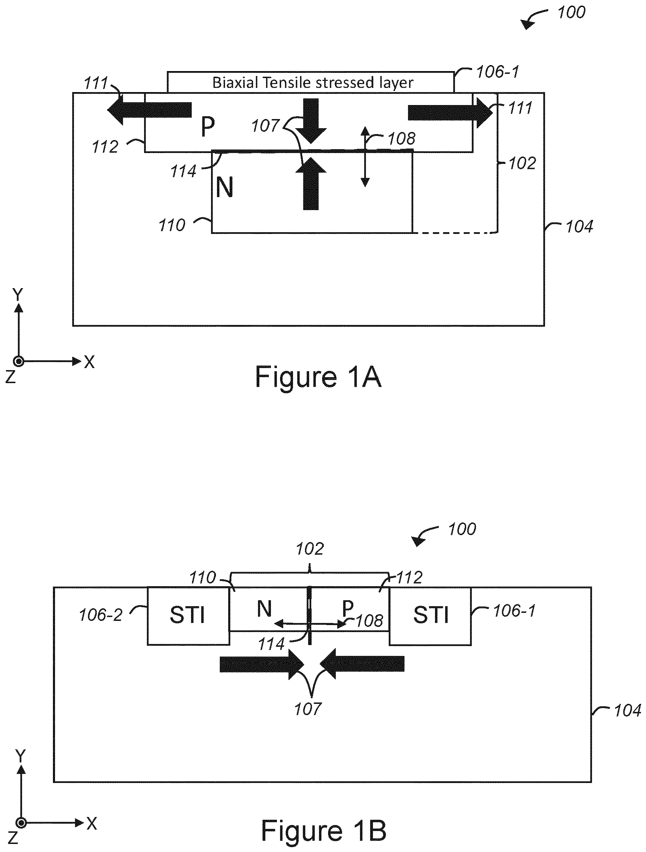

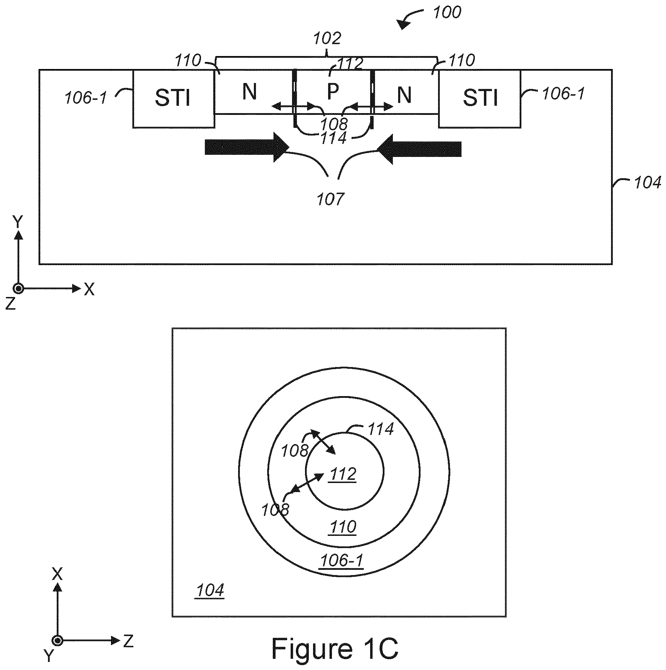

Figures 1A to 1C illustrate example Zener diodes 100 according to respective embodiments of the present disclosure. The figures illustrate a cross-section of the Zener diode 100. Figure 1C further illustrates a plan view of the respective Zener diode.

The Zener diode 100 comprises a PN junction 102 formed in a semiconductor material 104, and one or more stress-inducing regions 106-1, 106-2 configured to impart a compressive stress (illustrated by arrows 107) in the PN junction 102 along a current flow direction 108 of the PN junction 102.

The PN junction 102 may comprise a N-type region 110 in contact with a P-type region 112. The current flow direction 108 is perpendicular to an interface 114 of the N-type region 110 with the P-type region 112 (i.e. the PN junction 102). In other words, the current flow direction 108 is perpendicular to the PN junction 102. The current flow direction 108 is illustrated as being from the P-type region 112 to the N-type region 110 and vice-versa because the current flow direction 108 will vary depending on whether the PN junction 102 is forward biased or reverse biased.

The one or more stress-inducing regions 106-1, 106-2 may comprise either or both of: (i) a first stress-inducing region 106-1 in contact with the P-type region 112; and (ii) a second stress-inducing region 106-2 in contact with the N-type region 114. For example, the Zener diode of Figure 1A may have the positions of the N-type region 110 and the P-type region 112 reversed such that the N-type region 110 is in contact with the stress-inducing region.

The semiconductor material 104 may comprise a semiconductor substrate such as a semiconductor epitaxial layer.

Turning specifically to the first example of Figure 1A, the Zener diode 100 can comprise a layered structure. In this example, the N-type region 110 comprises a first layer formed in the semiconductor material 104 and the P-type region 112 comprises a second layer formed in the semiconductor material 104 positioned between the first layer and a surface of the semiconductor material 104. As referred to herein, the surface of the semiconductor material 104 may refer to a top surface or a contact surface of the semiconductor material 104, i.e. the top surface as illustrated in each of Figures 1A-1C, 2A-2E and 3A-3D. In other examples, the N-type region 110 may form the second layer and the P-type region 112 may form the first layer.

The first layer and the second layer both extend along orthogonal axes (X, Z) parallel to a (XZ) plane of the surface of the semiconductor material 104. In other words, the first and second layers extend in a plane parallel to the place of the surface of the semiconductor material 104. The first layer and the second layer form the PN junction 102. As a result, the current flow direction 108 is in an axis (Y) perpendicular to the interface 114 of the PN junction (interface of first and second layers), i.e. in an axis (Y) perpendicular to the (XZ) plane of the surface of the semiconductor material 104.

In this example, the one or more stress-inducing regions 106-1, 106-2 comprise a stress-inducing layer 106-1 positioned on the surface of the semiconductor material 104. In some examples, the stress-inducing layer 106-1 may be positioned directly on the surface of the semiconductor material 104 (as illustrated). In other examples, the stress-inducing layer 106-1 may be positioned indirectly on the surface of the semiconductor material 104 with one or more intervening layers positioned between the semiconductor surface and the stress-inducing layer 106-1. In this example, a surface of the second layer forms the surface of the semiconductor material 104 such that the stress-inducing layer 106-1 is positioned on the second layer.

The stress-inducing layer 106-1 may comprise a tensile stressed layer 106-1 that imparts a tensile stress in one or more axes parallel to the (XZ) plane of the second layer / surface of the semiconductor material 104 (as illustrated in the figure by arrows 111). In other words, the tensile stressed layer 106-1 stretches the PN junction 102 laterally along one or more axes parallel to the (XZ) plane of the second layer / surface, i.e. perpendicular to the current flow direction 108. By stretching the PN junction 102 perpendicular to the current flow direction 108, the tensile stress layer imparts a compressive stress to the PN junction 102 along the current flow direction 108.

In this example, the tensile stressed layer 106-1 comprises a biaxial tensile stressed layer that imparts the tensile stress along two axes that are both parallel to the plane of the surface of the semiconductor material 104. The biaxial tensile stressed layer may comprise a Silicon Nitride layer. A tensile stressed silicon nitride layer can be deposited, for example, by Low pressure chemical vapor deposition or plasma enhanced chemical vapor deposition from reactants including dichlorosilane and ammonia. The deposition conditions, reactants, and reactant flows can be adjusted to desired stress value. In other examples, the tensile stressed layer 106-1 may comprise a uniaxial tensile stressed layer that imparts the tensile stress along a single axis parallel to the plane of the surface of the semiconductor material 104.

As illustrated, the PN junction 102 is formed at the top surface of the semiconductor material 104, with the N-type layer 110 formed in the semiconductor material 104 and the P-type layer 112 formed on top of the N-type layer 110 with the top surface of the P-type layer 112 forming the top surface of the semiconductor material 104. The stress-inducing layer 116-1 is formed /deposited on top of the P-type layer 112 I top surface of the semiconductor material 104.

In some examples, one or more dimensions (thickness/depth, area, width, length etc) of the stress-inducing layer / region 106-1 may be selected to control the value of the compressive stress along the current direction 108 in the PN junction 102.

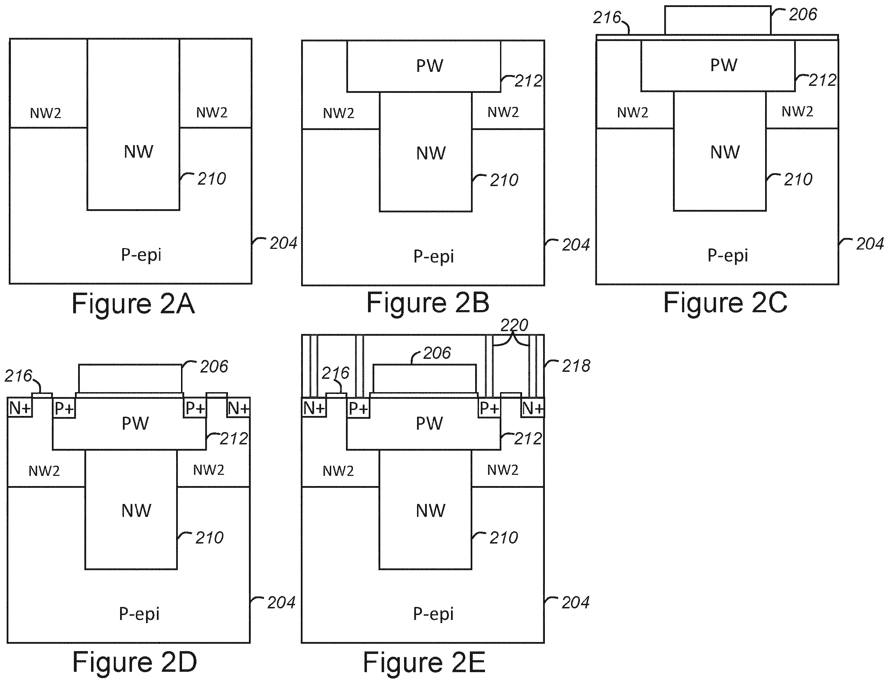

Figures 2A to 2E illustrate an example process for forming the Zener diode of Figure 1A. Features of Figures 2A to 2E that are also present in Figures 1a-1C have been given corresponding numbers in the 200 series and will not necessarily be described again here.

In a first stage, illustrated in Figure 2A, a first N-type region, NW, 210 and a second N-type region, *NW2,* are formed in a semiconductor material 204. In this example, the semiconductor material 204 comprises a P-type Silicon epitaxial substrate, *P-epi.* The first N-type region 210 corresponds to the N-type region of the PN junction and in this example comprises a N-Well region formed by heavy N-type implantation / doping (e.g. Phosphorous implantation). The second N-type region, NW2, comprises a lighter doped N-type region for cathode coupling. The different first and second N-type regions may be formed by suitable known masking and implantation steps.

In a second stage illustrated in Figure 2B, the semiconductor material 204 is implanted with P-type material to form the P-type region, *PW,* 212 of the PN junction. In this example, the P-type region comprises a P-Well region formed by heavy P-type implantation / doping (e.g. Boron implantation). As with the first stage, formation of the P-type region may be performed using known masking and implantation steps.

The doping level of the P-type region 212, the first N-type region 212 and the second N-type region may respectively comprise $10^{19}$ - $10^{20}$ cm$^{-3}$, $10^{18}$-$10^{19}$ cm$^{-3}$ and $10^{17}$-$10^{18}$ cm$^{-3}$.

In a third stage, illustrated in Figure 2C, the stress-inducing layer 206 is deposited on a surface of the semiconductor material 204. In some examples, the stress-inducing layer 206 may be deposited directly on the surface of the semiconductor material 204. In other examples, like the example illustrated, the stress-inducing layer 206 may be deposited indirectly on the surface of the semiconductor material 204 with an intervening layer positioned between the stress-inducing layer 206 and the top surface of the semiconductor material 204. In this example, a silicon oxide layer 216 is deposited on the surface of the semiconductor material 204 prior to depositing the stress-inducing layer 206. The oxide layer 216 provides a dielectric barrier on top of the doped semiconductor material 204. In this example, the stress-inducing layer 206 comprises a biaxially tensile stressed layer and in particular a nitride layer, such as Silicon Nitride. The stress-inducing layer 206 may comprise a thickness of 10 nm or greater.

In a fourth stage, illustrated in Figure 2D, heavily doped P-type contact regions, *P+*, are formed in the P-type region 212 and heavily doped N-type contact regions, *N+*, are formed in the second N-type region, *NW2.* Windows are etched in the silicon oxide layer 216 prior to implantation with the corresponding dopant material to form the heavily doped contact regions *N+, P+.* Known masking and implantation techniques may be used to form the heavily doped contact regions, *N+, P+.*

In a fifth stage, illustrated in Figure 2E, an insulating layer 218 is deposited over the semiconductor material 204. In this example the insulating layer comprises Tetraethyl Orthosilicate (TEOS). Openings are etched in the TEOS in line with, and down to the surface of, the heavily doped contact regions, *N+, P+.* The openings are filled with a metal (e.g. Copper, Gold etc) to create contacts 220 for the Zener diode. In this example, the Zener diode has structural symmetry about an axis along the current flow direction, such that the heavily doped N-type contact region, *N+*, heavily doped P-type region, *P+*, and corresponding metal contacts 220 form respective ring regions and contacts. In other words, there is one anode ring contact coupled to the ring structured heavily doped P-type region, *P+*, and one cathode ring contact coupled to the ring structured heavily doped N-type region, *N+*.

Returning to Figure 1B, a second example Zener diode 100 is illustrated according to an embodiment of the present disclosure.

In this example, the PN junction 102 is formed laterally in the semiconductor material 104. The N-type region 110 is positioned adjacent to the P-type region 112 (in the same layer) and the interface 114 of the PN junction 102 is perpendicular to the top surface of the semiconductor material 104. As a result, the current flow direction 108 is parallel to the (XZ) plane of the top-surface of the semiconductor material 104.

The one or more stress-inducing regions 106-1, 106-2 may comprise either or both of: a first stress-inducing region 106-1 adjacent to the P-type region 112 (and at an opposite side to the N-type region 110); and (ii) a second stress-inducing region 106-2 adjacent to the N-type region 110 (and at an opposite side to the P-type region 112). In the example, shown, the PN junction 102 is formed between a first stress-inducing region 106-1 and a second stress-inducing region 106-2.

In this example, the one or more stress-inducing regions 106-1, 106-2 comprise shallow trench isolation (STI) features. STI is a feature used in ICs to prevent electric current leakage between adjacent semiconductor device components. They are typically formed by etching a trench in the semiconductor material 104 and depositing a dielectric such as silicon dioxide into the trench. Due to different mechanical properties of oxide and silicon, compressive stress can develop laterally along the current flow direction 108. STI features can exhibit residual thermal stress following the fabrication process (due to a difference in thermal expansion coefficient between the semiconductor material 104 and the dielectric material). The STI features may impart the residual thermal stress in a lateral (X-axis) direction parallel to the (XZ) plane of the surface of the semiconductor material 104. In this way, the STI features can act as stress-inducing regions 106-1, 106-2 and impart compressive stress on the PN junction 102 in the current flow direction 108.

In some examples, a separation of the first stress-inducing region 106-1 and the second stress-inducing region 106-2 may be selected to control a value of the compressive stress along the current direction 108 in the PN junction 102. In some examples, one or more dimensions (thickness/depth, area, width, length etc) of the one or more stress-inducing regions 106-1, 106-2 may be selected to control the value of the compressive stress along the current direction 108 in the PN junction 102.

Figure 1C illustrates a further example Zener diode 100 according to an embodiment of the present disclosure. The Zener diode has a lateral structure similar to that of Figure 1B, however, the structure also has circular symmetry about a vertical (Y) axis as illustrated by the plan view in the lower half of the figure.

The PN junction 102 comprises a P-type region 112 surrounded by a N-type region 110 within a junction layer of the semiconductor material 104. The junction layer extends in a (XZ) plane parallel to the (XZ) plane of the top surface of the semiconductor material 104. The interface 114 between the P-type region 112 and the N-type region 110 is perpendicular to the surface of the semiconductor material 104 and extends circumferentially around the P-type region 112. The current flow direction 108 is perpendicular to the interface 114 and extends radially from the centre of the P-type region 112.

The PN junction 102 is surrounded by a stress-inducing region 106-1. In other words, the N-type region 110 is surrounded by the stress-inducing region 106-1. The stress-inducing region 106-1 imparts compressive stress to compress the PN junction 102 in a radial direction towards the centre of the P-type region 112. In this way, the stress-inducing region 106-1 imparts compressive stress in the current flow direction 108.

In this example, the P-type region 112 is surrounded by the N-type 110 region, however in other examples, the N-type region 110 may be surrounded by the P-type region 112. In some examples, the diode 100 may comprise a lower level of rotational symmetry than circular symmetry, for example, order 8, order 6, order 4 or order 2 rotational symmetry. For example, the P-type region 112, N-type region 110 and stress-inducing region 106-1 may have a rectangular structure when viewed from above.

In some examples, one or more of: the radius of the P-type region 112; the radius of the N-type region 110; and the radius of the stress-inducing region 106-1 may be selected to control a value of the compressive stress in the current flow direction 108 within the PN junction 102.

In some examples, the depth or width of the stress-inducing region 106-1 may be selected to control the value of the compressive stress in the current flow direction 108 within the PN junction 102.

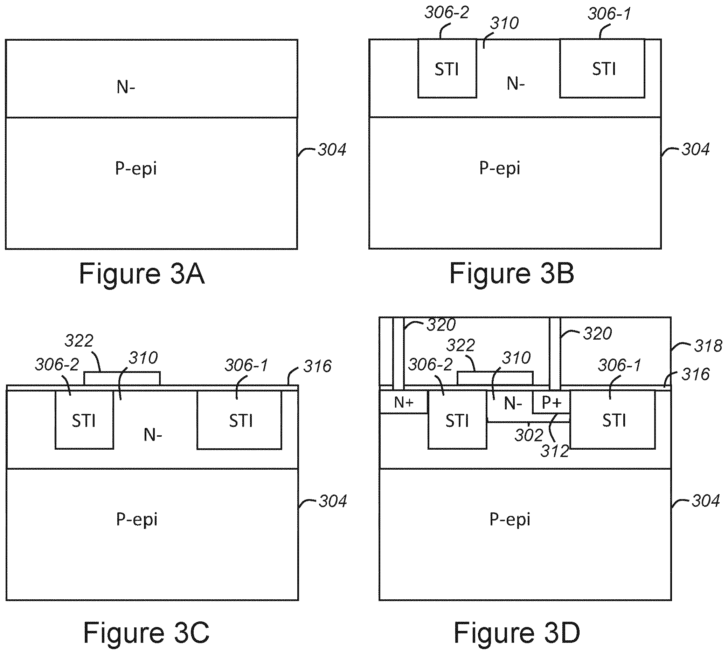

Figures 3A to 3D illustrate an example process for forming the Zener diode of Figures 1B and 1C. Features of Figures 3A to 3D that are also present in Figures 1A-1C and 2A-2E have been given corresponding numbers in the 300 series and will not necessarily be described again here.

In a first stage, illustrated in Figure 3A, a N-type region, N-, is formed in a semiconductor material 304. In this example, the semiconductor material 304 comprises a P-type Silicon epitaxial substrate, *P-epi*. A portion of the N-type region, *N-,* will form the N-type region 310 of the PN junction 302 and in this example comprises a N-Well region formed by heavy N-type implantation / doping (e.g. Phosphorous implantation). The N-type region, *N-*, may be formed by suitable known masking and implantation steps.

In a second stage, illustrated in Figure 2B, one or more stress-inducing regions 306-1, 306-2 are formed in the semiconductor material 204. In this example, the stress-inducing regions 306-1, 306-2 are formed as STI features by etching a trench in the semiconductor material 304 and depositing a dielectric material such as Silicon Dioxide in the trench. The portion of the N-type region between a first stress-inducing region 306-1 and a second stress-inducing region 306-2 forms the N-type region 310 of the PN junction 302.

In a third stage, illustrated in Figure 3C, a silicon oxide layer 316 is deposited on the surface of the semiconductor material 304. The oxide layer 316 provides a dielectric barrier on top of the doped semiconductor material 304. Following deposition of the oxide layer 316, a mask layer 322 is deposited on the oxide layer, so that a portion of the N-type region 310 between the STI regions 306-1, 306-2 is partially exposed. In this example the mask layer 322 comprises a nitride layer.

In a fourth stage, illustrated in Figure 3D, a heavily doped P-type contact region, P+, and a heavily doped N-type contact region, *N+*, are formed in the N-type region, *N-*. Windows may be etched in the silicon oxide layer 316 prior to implantation with the corresponding dopant material to form the heavily doped contact regions *N+, P+*. Known masking and implantation techniques may be used to form the heavily doped contact regions, *N+, P+*. The P-type contact region, *P+*, is formed by implanting P-type dopants in the N-type region, *N-*, between the first and second STI regions 306-1, 306-2. In this way, the PN junction 302 is formed between the first and second stress-inducing regions 306-1, 306-2 and the stress-inducing regions impart a compressive stress in the PN junction 302 in the current flow direction. A TEOS layer 318 is deposited over the semiconductor material 304 and metal contacts 320 are formed as described above.

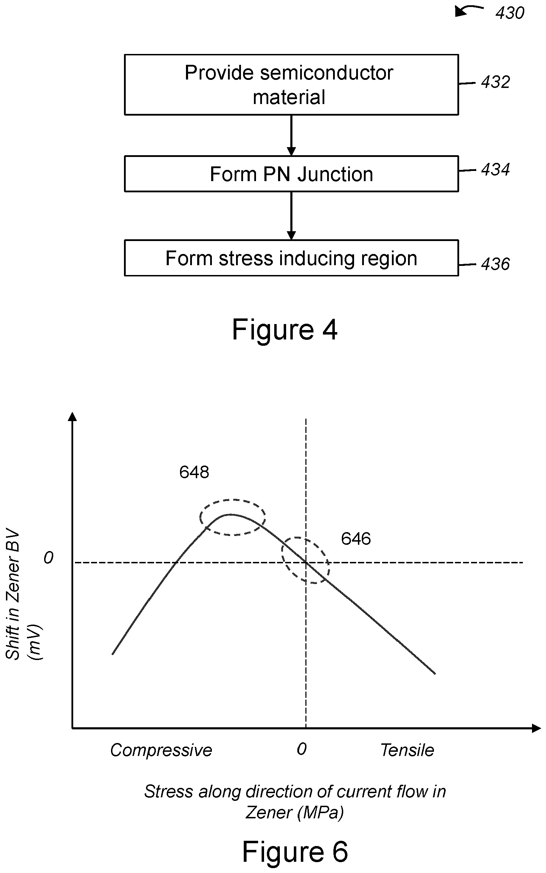

Figure 4 illustrates a method 430 of manufacturing a Zener diode according to an embodiment of the present disclosure.

A first step 432 comprises providing a semiconductor material. A second step 434 comprises forming a PN junction in the semiconductor material. A third step 436 comprises forming one or more stress-inducing regions in or on the semiconductor material, wherein the one or more stress-inducing regions are configured to impart a compressive stress in the PN junction along a current flow direction of the PN junction.

There now follows a description of the theory underlying the improvement in Zener diode performance arising from the compressive stress in the current flow direction.

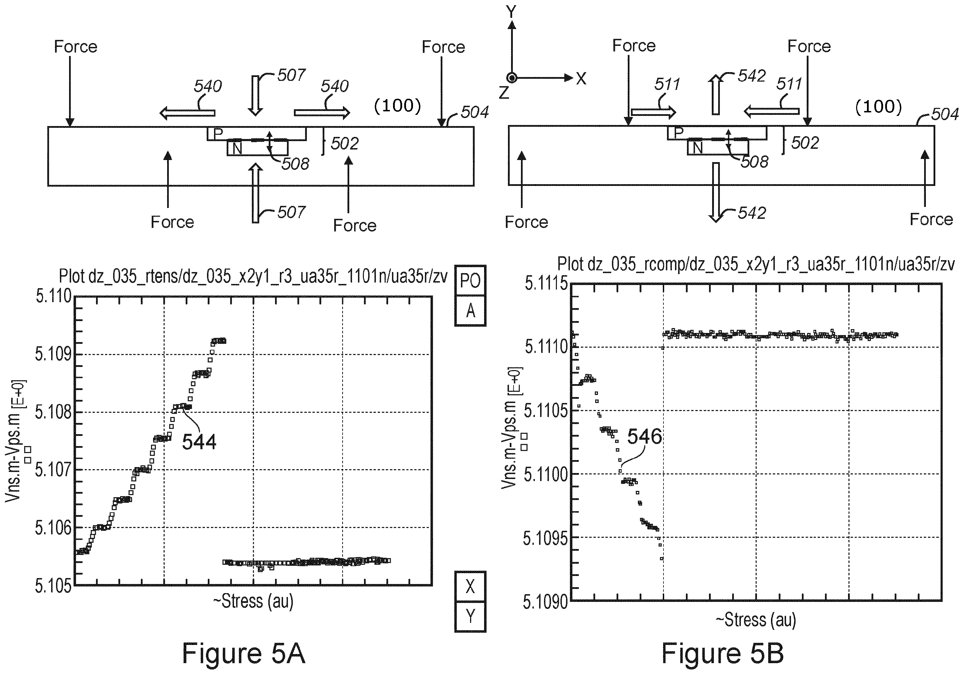

Figures 5A and 5B illustrate the effects of tensile stress and compressive stress on the performance of a PN junction.

Figure 5A illustrates a change in breakdown voltage 546 in response to the application of compressive stress along the current flow direction 508 of a PN junction 502. The PN junction 502 is formed at a top surface of a semiconductor material 504. Force is then applied to bend the semiconductor material into a ⌒-shape. This results in tensile stress (illustrated by arrows 511) on the PN-junction 502 in a lateral direction i.e. parallel to the XZ plane of the top surface. The tensile lateral stress 511 results in compressive stress 507 in the current flow direction 508 of the PN junction 502.

The plot illustrates the measured increase in breakdown voltage 544 resulting from this increase in compressive stress 507 along the current flow direction 508.

Figure 5B illustrates a change in breakdown voltage 544 in response to the application of tensile stress along the current flow direction 508 of a PN junction 502. The PN junction 502 is formed at a top surface of a semiconductor material 504. Force is then applied to bend the semiconductor material into a U-shape. This results in compressive stress (illustrated by arrows 540) on the PN-junction in a lateral direction i.e. parallel to the plane of the top surface. The compressive lateral stress 540 results in tensile stress 542 in the current flow direction 508 of the PN junction.

The plot illustrates the measured decrease in breakdown voltage 546 resulting from this increase in tensile stress along the current flow direction 508.

Figure 6 illustrates a simulation of the variation in Zener breakdown voltage in dependence of stress along the current flow direction. Positive values of stress correspond to tensile strain and negative values correspond to compressive strain.

A nominally unstressed region 646 of the plot has a relatively steep gradient illustrating that nominally unstressed Zener diodes are subject to relatively high variations in breakdown voltage when subject to stress along the current flow direction of the PN junction.

At a certain compressive stress, the plot reaches a peak region 648 and shows a smaller sensitivity to a variation in stress resulting from external or packaging stress. The disclosed Zener diodes comprise one or more stress-inducing regions for imparting compressive stress along the current flow direction of the PN junction to move the Zener diode to this region 648 of reduced breakdown voltage sensitivity. As a result, the disclosed Zener diodes advantageously exhibit a reduced breakdown voltage sensitivity to external stress and packaging stress.

The shape of the plot of Figure 6 can be explained as follows. The breakdown voltage relates inversely to the tunnel rate, $\Theta$, of electrons, which can be described by the equation:

$$\Theta = \exp\left(-\frac{4}{3}\frac{\sqrt{2m^*}}{q\hbar}\frac{E_g^{3/2}}{\varepsilon}\right)$$

Here, q is the electron charge, $\hbar$ is the reduced Planck constant, $\varepsilon$ is a correction factor for the Band-gap, $E_g$, of the semiconductor material and $m^*$ is the tunnel mass of the electron. The tunnel rate, $\Theta$, increases with both increasing tunnel mass, $m^*$, and increasing band-gap, $E_g$. The tunnel mass may be approximated as the effective mass of the electron at the bottom of the conduction band, $m_c$. Due to anisotropy in the Silicon conduction band, the conduction mass, $m_c$, increases while the band gap, $E_g$, decreases when compressive stress is applied along the current flow direction. This leads to the cross-over point / peak 648 in the plot (at lower values of compressive stress, the increase in the conduction mass, $m_c$, dominates, at higher values, the decrease in band gap energy, $E_g$, dominates). For the application of tensile stress along the current flow direction, both the conduction mass, $m_c$, and the bandgap, $E_g$, decrease leading to an increase in tunnelling rate and lower breakdown voltage.

In view of the above, the one or more stress-inducing regions of the disclosed Zener diodes may impart compressive stress along the current flow direction of the PN junction, such that the breakdown voltage of the Zener diode has a reduced sensitivity to a variation in stress along the current flow direction (relative to the unstressed state). In other words, the value of the compressive stress is selected to reduce a derivative of the breakdown voltage with respect to the compressive stress. In some examples, the compressive stress may be between 150 MPa and 200MPa.

The present disclosure provides example Zener diodes incorporating built-in compressive stress along a current flow direction that provides for reduced sensitivity of the Zener breakdown voltage to package stress or external stress. This is in contrast to conventional Zener diode design in which stress within the diode and PN junction is typically minimized.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

**Claims**

1. A Zener diode comprising:

   a PN junction formed in a semiconductor material; and
   one or more stress-inducing regions configured to impart a compressive stress in the PN junction along a current flow direction of the PN junction.

2. The Zener diode of claim 1, wherein the PN junction comprises a N-type region in contact with a P-type region and the one or more stress-inducing regions comprise one or more of:

   a first stress-inducing region in contact with the P-type region; and
   a second stress-inducing region in contact with the N-type region.

3. The Zener diode of claim 1 or claim 2, wherein one or more dimensions of the one or more stress-inducing regions is selected to control a value of the compressive stress in the PN junction along the current flow direction of the PN junction.

4. The Zener diode of any preceding claim, wherein the Zener diode comprises a layered structure including:

   a first layer formed in the semiconductor material;
   a second layer formed in the semiconductor material between the first layer and a surface of the semiconductor material; and
   a stress-inducing layer positioned on the surface of the semiconductor material to form one of the one or more stress-inducing regions,
   wherein the first layer and the second layer each comprise a different one of a P-type region and a N-type region to form the PN junction.

5. The Zener diode of claim 4, wherein the stress-inducing layer comprises a tensile stressed layer configured to impart a tensile stress to the second layer in one or more axes parallel to a plane of the second layer.

6. The Zener diode of claim 5, wherein the stress-inducing layer comprises a biaxial tensile stressed layer.

7. The Zener diode of any of claims 4 to 6, wherein the stress-inducing layer is indirectly positioned on the surface of the semiconductor material and an oxide layer is positioned between the surface of the semiconductor material and the stress-inducing layer.

8. The Zener diode of any of claims 1 to 3, wherein the PN junction comprises a N-type region positioned adjacent to a P-type region with an interface between the N-type region and the P-type region being perpendicular to a top surface of the semiconductor material, wherein the one or more stress-inducing regions comprise one or more of:

   a first stress-inducing region adjacent to the P-type region on an opposite side to the N-type region; and
   a second stress-inducing region adjacent to the N-type region on an opposite side to the P-type region.

9. The Zener diode of claim 8, wherein the one or more stress-inducing regions each comprise a shallow trench isolation feature.

10. The Zener diode of claim 8 or claim 9, wherein the one or more stress-inducing regions comprise:

   a first stress-inducing region adjacent to the P-type region on an opposite side to the N-type region; and
   a second stress-inducing region adjacent to the N-type region on an opposite side to the P-type region,
   wherein a separation of the first stress-inducing region and the second stress-inducing region is selected to control a value of the compressive stress in the PN junction in the current flow direction.

11. The Zener diode of any of claims 1 to 3, wherein the Zener diode comprises:

   a first region formed in the semiconductor material; and
   a second region formed in the semiconductor material and surrounding the first region to form a PN junction in a junction plane, wherein the first region and the second region each comprise a different one of a P-type region and a N-type region to form the PN junction,
   wherein the one or more stress-inducing regions include a stress-inducing region surrounding the second region.

12. The Zener diode of claim 11, wherein the stress-inducing region comprises a shallow trench isolation feature.

13. The Zener diode of any preceding claim, wherein the semiconductor material comprises Silicon.

14. An integrated circuit comprising the Zener diode of any preceding claim.

15. A method of manufacturing a Zener diode comprising the steps of:

   providing a semiconductor material;
   forming a PN junction in the semiconductor material; and
   forming one or more stress-inducing regions in or on the semiconductor material, wherein the one or more stress-inducing regions are configured to impart a compressive stress in the PN junction along a current flow direction of the PN junction.

Figure 1A

Figure 1B

Figure 1C

Figure 2A

Figure 2B

Figure 2C

Figure 2D

Figure 2E

EP 4 651 183 A1

**Figure 3A**

N-

P-epi ~304

**Figure 3B**

306-2  310  306-1

STI  N-  STI

P-epi ~304

**Figure 3C**

322
306-2  310  306-1  316

STI  N-  STI

P-epi ~304

**Figure 3D**

320  320  318
322  310  316
306-2  306-1

N+  STI  N-  P+  STI
302  312

P-epi ~304

430

| Provide semiconductor material | — 432 |
| Form PN Junction | — 434 |
| Form stress inducing region | — 436 |

Figure 4

648

646

Shift in Zener BV (mV)

0

Compressive        0        Tensile

Stress along direction of current flow in Zener (MPa)

Figure 6

EP 4 651 183 A1

Y

Z ⊙ —→ X

Force                                     Force

540                507        540           (100)
                                                    504
                P                          502
                  N
                    508        507

Force                                     Force

Plot dz_035_rtens/dz_035_x2y1_r3_ua35r_1101n/ua35r/zv   | PO |
                                                         | A |

5.110 ⌐

Vns.m-Vps.m [E+0]

5.109 ┤

5.108 ┤                                544

5.107 ┤

5.106 ┤

5.105 ┴

~Stress (au)

| X |
| Y |

**Figure 5A**

Force                                     Force

511                542        511           (100)
                                                    504
                P                          502
                  N
                    508

Force                                     Force
                   542

Plot dz_035_rcomp/dz_035_x2y1_r3_ua35r_1101n/ua35r/zv

5.1115 ⌐

5.1110 ┤

Vns.m-Vps.m [E+0]

5.1105 ┤         546

5.1100 ┤

5.1095 ┤

5.1090 ┴

~Stress (au)

**Figure 5B**

Europäisches
Patentamt

European
Patent Office

Office européen
des brevets

# EUROPEAN SEARCH REPORT

**Application Number**

EP 24 17 5943

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/020277 A1 (SINGH JAGAR [US] ET AL) 21 January 2016 (2016-01-21) | 1-3, 8-10, 13-15 | INV.<br>H01L21/329<br>H01L29/866 |
| A | * paragraphs [0025], [0035], [0037]; figures 7, 9 *<br>----- | 4-7 | ADD.<br>H01L29/06 |
| X | US 2019/081040 A1 (KANAYA TOSHIYUKI [JP] ET AL) 14 March 2019 (2019-03-14) | 1-3, 11-13,15 | |
| A | * paragraphs [0037], [0074] - [0076]; figures 2,4 *<br>----- | 4-7 | |
| A | US 2016/276447 A1 (SIMOLA ROBERTO [FR] ET AL) 22 September 2016 (2016-09-22)<br>* the whole document *<br>----- | 1-15 | |
| A | US 5 936 288 A (TSUCHIDA KAZUHITO [JP] ET AL) 10 August 1999 (1999-08-10)<br>* Fig. 1 and related text *<br>----- | 1-15 | |

| | TECHNICAL FIELDS SEARCHED (IPC) |
|---|---|
| | H01L |

The present search report has been drawn up for all claims

| Place of search | Date of completion of the search | Examiner |
|---|---|---|
| Munich | 7 October 2024 | Melodia, Andrea |

EPO FORM 1503 03.82 (P04C01)

## ANNEX TO THE EUROPEAN SEARCH REPORT
## ON EUROPEAN PATENT APPLICATION NO.

EP 24 17 5943

This annex lists the patent family members relating to the patent documents cited in the above-mentioned European search report.
The members are as contained in the European Patent Office EDP file on
The European Patent Office is in no way liable for these particulars which are merely given for the purpose of information.

07-10-2024

| Patent document cited in search report | | Publication date | Patent family member(s) | | Publication date |
|---|---|---|---|---|---|
| US 2016020277 | A1 | 21-01-2016 | US | 2015194419 A1 | 09-07-2015 |
| | | | US | 2016020204 A1 | 21-01-2016 |
| | | | US | 2016020277 A1 | 21-01-2016 |
| US 2019081040 | A1 | 14-03-2019 | NONE | | |
| US 2016276447 | A1 | 22-09-2016 | CN | 105990452 A | 05-10-2016 |
| | | | CN | 111599871 A | 28-08-2020 |
| | | | CN | 205159337 U | 13-04-2016 |
| | | | FR | 3033938 A1 | 23-09-2016 |
| | | | US | 2016276447 A1 | 22-09-2016 |
| | | | US | 2017148926 A1 | 25-05-2017 |
| US 5936288 | A | 10-08-1999 | DE | 19810579 A1 | 14-01-1999 |
| | | | JP | H1126600 A | 29-01-1999 |
| | | | US | 5936288 A | 10-08-1999 |

EPO FORM P0459

For more details about this annex : see Official Journal of the European Patent Office, No. 12/82